# EUROPÄISCHE PATENTSCHRIFT

(11) **EP 0 825 447 B1**
(45) Veröffentlichungstag und Bekanntmachung des Hinweises auf die Patenterteilung: **02.04.2008**
(21) Anmeldenummer: 97810402.4
(22) Anmeldetag: 24.06.1997
(51) Int. Cl.: G01R 15/14, H02B 13/065

(54) **Messvorrichtung für eine metallgekapselte, gasisolierte Hochspannungsanlage**
Measuring device for a metal-encapsulated gas-insulated high voltage installation
Appareil de mesure pour une installation blindée à haute tension à isolation de gaz

(30) Priorität: 23.08.1996 DE 19634236
(43) Veröffentlichungstag der Anmeldung: 25.02.1998
(73) Patentinhaber: ABB Schweiz AG, 5400 Baden (CH)
(72) Erfinder: Bosco, Antonio, 4806 Wikon (CH); Hertig, Thomas, Greensburg, PA 15601 (US); Kaczkowski, Andrzej, Dr., 5303 Würenlingen (CH)
(74) Vertreter: ABB Patent Attorneys

(56) Entgegenhaltungen:
- EP-A- 0 522 303
- WO-A-96/18909
- DE-A- 4 137 865
- US-A- 3 869 665
- SCHETT G ET AL: "INTELLIGENT GIS - A FUNDAMENTAL CHANGE IN THE WAY PRIMARY AND SECONDARY EQUIPMENT IS COMBINED" ABB REVIEW, Nr. 8, 1. Januar 1996 (1996-01-01), Seiten 4-14, XP000633194 ISSN: 1013-3119

## Beschreibung

### TECHNISCHES GEBIET

Bei der Erfindung wird ausgegangen von einer Messvorrichtung für eine metallgekapselte, gasisolierte Hochspannungsanlage nach dem Oberbegriff von Patentanspruch 1. Eine derartige Messvorrichtung enthält mindestens eine in einem isoliergasgefüllten Kapselungsrohr der Metallkapselung angeordnete Rogowskispule zur Messung des Stromes eines durch das das Kapselungsrohr geführten strombeaufschlagten Leiters. Eine den Leiter umfassende Messelektrode dient der Messung der Spannung dieses Leiter. Zusätzliche physikalischer Grössen der Anlage, wie etwa der Druck, die Temperatur und/oder die Dichte des Isoliergases oder das Auftreten von Teilentladungen, können mit weiteren in der Messvorrichtung vorgesehen Sensoren gemessen werden.

### STAND DER TECHNIK

Die Erfindung nimmt dabei Bezug auf einen Stand der Technik von Messvorrichtungen für metallgekapselte, gasisolierte Hochspannungsanlagen,wie er etwa aus EP 0 510 311 A2 und EP 0 522 303 A2 bekannt ist. Ein in diesem Stand der Technik beschriebener kombinierter Strom- und Spannungswandler für eine metallgekapselte, gasisolierte Hochspannungsanlage enthält im Inneren eines isoliergasgefüllten Kapselungsrohrs der Metallkapselung eine um einen stromführenden Leiter geführte und der Messung des Leiterstromes dienende Rogowskispule sowie eine konzentrisch zum Leiter in elektrisch isolierender Weise angeordnete rohrförmige Metallelektrode, welcher der Messung der Leiterspannung dient. Von der Rogowskispule und der Messelektrode abgebene Ausgangssignale werden in abgeschirmten Leitungen durch die Wand des Kapselungsrohrs zu einer von der Metallkapselung entfernt liegenden Auswerteelektronik geführt, in der aus den Ausgangssignalen Messwerte gebildet werden, die dem im Stromleiter führenden Strom bzw. der am Stromleiter anliegenden Spannung entsprechen.

### KURZE DARSTELLUNG DER ERFINDUNG

Der Erfindung, wie sie in Patentanspruch 1 definiert ist, liegt die Aufgabe zugrunde, eine Messvorrichtung für eine metallgekapselte, gasisolierte Hochspannungsanlage mit im Kapselungsrohr der Metallkapselung angeordneten und als Rogowskispule und Messelektrode ausgebildeten Sensoren anzugeben, welche sich durch eine grosse Messgenauigkeit und eine grosse Betriebssicherheit auszeichnet.

Bei der Messvorrichtung nach der Erfindung ist der Stromleiter starr mit einem Isolator verbunden, welcher seinerseits starr auf dem Kapselungsrohr abgestützt ist. Anstelle der sonst üblichen schwimmenden Lagerung des Stromleiters auf Federkontakten sowie durch definierte Halterung von Leiterabschirmungen kann so eine definierte Feldgeometrie im Inneren des Kapselungsrohrs eingehalten werden. Dies ist von entscheidender Bedeutung für des Genauigkeit eines von der Messelektrode abgegebenen spannungsproportionalen Signals. Die von der Messvorrichtung abgegebenen Messwerte können so zur Lösung unterschiedlicher Aufgaben, wie Steuerung, Messung, Schutz und Energiezählung, eingesetzt werden. Die hierfür bisher benötigte grosse Zahl an Sensoren kann daher ganz erheblich reduziert werden.

### KURZE BESCHREIBUNG DER ZEICHNUNGEN

Bevorzugte Ausführungsbeispiele der Erfindung und die damit erzielbaren weiteren Vorteile werden nachfolgend anhand von Zeichnungen näher erläutert. Hierbei zeigt:
- Fig.1: in axialer Richtung geschnitten eine erste Ausführungsform einer Messvorrichtung nach der Erfindung mit einem Kapselungsrohr und einem im Rohrinneren angeordneten stromführenden Leiter sowie mit im Rohrinneren angeordneten und als Rogowskispule bzw. isolierte Messelektrode ausgebildeten Sensoren, und mit einem eine elektronische Auswertevorrichtung enthaltenden zweiteiligen Metallgehäuse,
- Fig.2: in axialer Richtung geschnitten eine gegenüber der ersten nur geringfügig abgewandelte zweite Ausführungsform der Messvorrichtung nach der Erfindung,
- Fig.3: eine Seitenansicht eines als Federleiste ausgebildeten Teils einer im Metallgehäuse angeordneten Steckvorrichtung zur Verbindung der Ausgänge der Sensoren mit der elektronischen Auswertevorrichtung,
- Fig.4: eine Seitenansicht von rechts auf einen das Metallgehäuse enthaltenden Teil der Messvorrichtung nach den Figuren 1 oder 2, und
- Fig.5: eine Untersicht eines als trogförmiges Gehäuseelement ausgeführten Teils des in der Messvorrichtung nach den Figuren 1 oder 2 enthaltenden Metallgehäuses.

### WEGE ZUR AUSFÜHRUNG DER ERFINDUNG

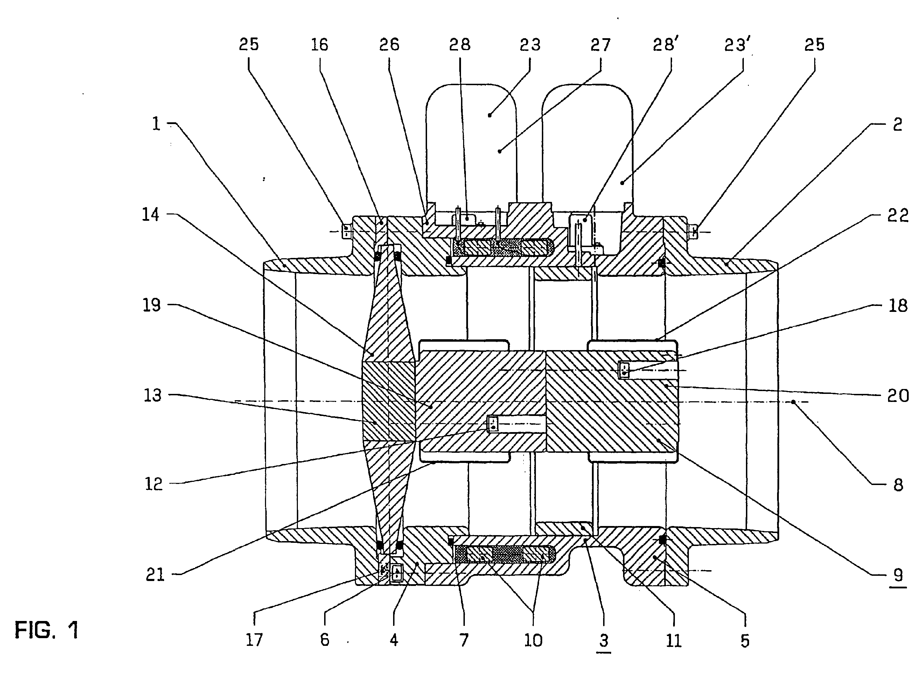

In allen Figuren bezeichnen gleiche Bezugszeichen auch gleichwirkende Teile. Die in Fig.1 dargestellte Messvorrichtung weist ein zwischen zwei Flanschen 1, 2 einer mit einem Isoliergas, wie insbesondere SF₆, von bis zu einigen bar Druck gefüllten Metallkapselung eingespanntes Kapselungsrohr 3 auf. Das Kapselungsrohr 3 ist von zwei jeweils einen Flansch aufweisenden metallenen Rohrabschnitten 4, 5, gebildet, welche mittels Schrauben 6 und eines Dichtungsrings 7 in gasdichter Weise miteinander verspannt sind. Auf der Achse 8 des Kapselungsrohrs 3 ist ein im wesentlichen zylinderförmig ausgebildeter und auf einem Hochspannungspotential von typischerweise mehreren hundert kV befindlicher Stromleiter 9 geführt. In einem von den beiden Rohrabschnitten 4, 5 begrenzten Hohlraum befinden sich zwei Rogowskispulen 10, welche den im Stromleiter 9 geführten Strom detektieren. Auf der dem Stromleiter 9 zugewandten Innenfläche des Kapselungsrohrs ist in einer von den Rohrabschnitten 4 und 5 begrenzten Ringnut eine gegenüber dem Kapselungsrohr 3 elektrisch isoliert angeordnete, die am Stromleiter 9 anliegende Hochspannung erfassende metallene Messelektrode 11 angebracht.

Der Stromleiter 9 ist mit Hilfe von Schrauben 12 starr verbunden mit einer auf der Achse 8 angeordneten Eingussarmatur 13 eines Isolators 14. Die Schrauben 12 sind in Richtung der Achse 8 geführt und sind mit einer Versiegelung (Siegellack) oder einer Plombierung gegen unbefugtes Betätigen geschützt. Der ringförmige Aussenrand des Isolators 14 ist mit Hilfe eines axial geführten Halteringes 16 am Flansch des Rohrabschnitts 4 fixiert. Den Haltering 16 am Rohrabschnitt 4 fixierende Schrauben 17 sind mit Hilfe einer Versiegelung oder einer Plombierung ebenfalls gegen unbefugtes Betätigen geschützt.

Der Stromleiter 9 wird ersichtlich von zwei durch axial geführte Schrauben 18 starr miteinander verbundenen Leiterabschnitte 19, 20 gebildet. Hierdurch wird erreicht, dass die den Stromleiter 9 am Isolator 14 fixierenden Schrauben 12 relativ kurz sein können. Die Schrauben 18 sind wie die Schrauben 12 und 17 durch eine Versiegelung oder durch eine Plombierung gegen unbefugtes Betätigen geschützt. Entsprechendes gilt auch für nicht bezeichnete weitere Schrauben, die der starren Befestigung von Abschirmungen 21, 22 am Stromleiter 9 dienen.

Durch die starre Befestigung des Stromleiters 9 am fest mit dem Kapselungsrohr 3 verbundenen Isolator 14 anstelle der sonst üblichen schwimmenden Lagerung des Stromleiters 9 auf Federkontakten sowie die definierte Halterung der Abschirmungen kann eine definierte Feldgeometrie im Inneren des Kapselungsrohrs 9 eingehalten werden. Dies ist von entscheidender Bedeutung für des Genauigkeit eines von der Messelektrode 11 abgegebenen spannungsproportionalen Signals. Durch die Sicherung der Schrauben 12, 17, 18 sowie der Abschirmungen 21, 22 wird erreicht, dass nach der Fertigstellung des hochspannungsbelasteten Teils der Messvorrichtung deren Feldgeometrie nicht verändert wird. Die in der Messvorrichtung enthaltenen Sensoren, wie die Rogowskispulen 10, die Messelektrode 11 sowie weitere gegebenenfalls vorhandene Sensoren, wie etwa Temperatur-, Druck- und Dichtefühler, Teilentladungssensoren und Lichtbogenwächter, können nun geeicht werden und die hierbei ermittelten Eichwerte sowie weitere Kenngrössen, wie Kompensationskurven, die beispielsweise temperaturbedingte Messabweichungen erfassen, in einem nicht überschreibbaren Datenspeicher (beispielsweise einem PROM) einer ausserhalb des isoliergasgefüllten Innenraums des Kapselungsrohrs 3 angeordneten elektronischen Auswertevorrichtung 23 der Messvorrichtung gespeichert werden. Dieser Datenspeicher kann durch Plombierung oder Versiegelung ebenfalls gegen unbefugtes Betätigen geschützt werden und ist lediglich der Elektronik der Auswertevorrichtung 23 zugänglich. Weist die Elektronik der Auswertevorrichtung 23 Mängel auf, so kann nach deren Austausch die neu in die Auswertevorrichtung eingesetzte Elektronik direkt auf die im PROM abgelegten Daten zugreifen. Kalibrierarbeiten beim Auswechseln der Elektronik können daher entfallen.

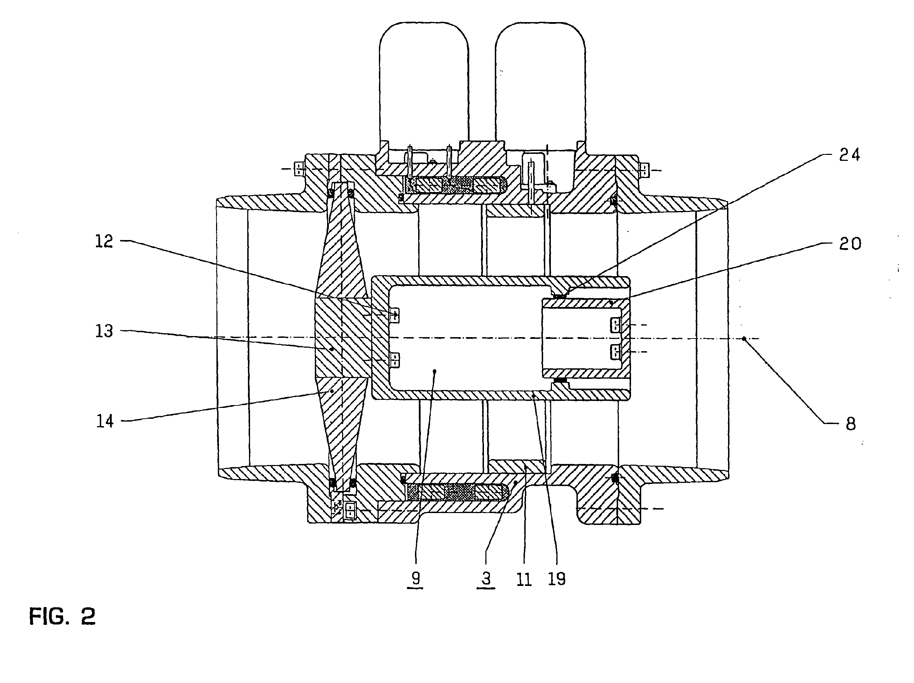

Der in der Messvorrichtung gemäss Fig.1 dargestellte Stromleiter 9 kann wie aus der Messvorrichtung gemäss Fig. 2 ersichtlich ist auch einen hohl ausgebildeten Abschnitt 19 aufweisen, der sich praktisch über die gesamte Länge des Kapselungsrohrs 3 erstreckt, zumindest aber durch die Messelektrode 11 geführt ist. Im Inneren des hohl ausgebildeten Leiterabschnitts 20 ist ein Gleitkontakt 24 vorgesehen, auf welchem der kürzer ausgebildete Leiterabschnitt 20 in axialer Richtung verschieblich elektrisch leitend gelagert ist. Durch gerundete Ausbildung der Enden des Leiterabschnitts 19 können die Abschirmungen 21, 22 eingespart werden.

Die Messvorrichtungen gemäss den Figuren 1 bzw. 2 können durch Verspannen des Flansches 1 und des Rohrabschnitts 4 sowie des Flansches 2 und des Rohrabschnitts 5 mit Hilfe von Spannschrauben 25 gasdicht (aus den Figuren ersichtliche nicht bezeichnete Dichtungsringe) in die Metallkapselung eingebaut werden.

Die Ausgänge der Rogowskispulen 10 und der Messelektrode 11 sind über abgeschirmte Messkabel und Gehäusedurchführungen, von denen die Gehäusedurchführung für das mit der Messelektrode 11 verbundene Messkabel gasdicht ausgeführt ist, an die in einem zweiteiligen Metallgehäuse untergebrachte Auswertevorrichtung 23 geführt. Eine weitere Auswertevorrichtung 23' kann in einem weiteren Metallgehäuse vorgesehen sein. Die Auswertevorrichtung 23 kann überwiegend zur Verarbeitung der Ausgangssignale der Rogowskispulen 10, die Auswertevorrichtung 23' überwiegend zur Verarbeitung der Ausgangssignale der Messelektrode 11 bestimmt sein. Die Ausgangssignale der Rogowskispulen 10 können aber auch in die Auswertevorrichtung 23' und umgekehrt die Ausgangssignale der Messelektrode 11 in die Auswertevorrichtung 23 geführt werden. Die Auswertevorrichtung 23 kann auch die Aufgaben der Auswertevorrichtung 23' und die Auswertevorrichtung 23' die Aufgaben der Auswertevorrichtung 23 übernehmen. Beide Auswertevorrichtung 23 und 23' können auch synchron zusammenwirken. Eine solche Messvorrichtung weist eine besonders grosse Redundanz auf, da beim Ausfall einer der beiden Auswertevorrichtungen die noch betriebsbereite Auswertevorrichtung die weitere Verarbeitung der Sensorausgangssignale durchführen kann.

Das eine Teil des Metallgehäuses ist jeweils von einem an die Aussenfläche des Kapselungsrohrs 3 angeformten metallenen Hohlflansch 26 und dem vom Hohlflansch umrandeten Bereich des Kapselungsrohrs 3 gebildet. Das andere Teil ist ein trogförmig vertieftes Gehäuseelement 27, welches mit seinem die Trogöffnung begrenzenden Rand am metallenen Hohlflansch 26 des Kapselungsrohrs 3 befestigt ist. In diesem Metallgehäuse ist die Auswertevorrichtung 23 vor elektromagnetischen und mechanischen Einwirkungen geschützt untergebracht. Da so lange Übertragungswege zwischen den Sensoren und der Auswertevorrichtung 23 und daraus resultierende Störungen entfallen, können die Verarbeitungsgeschwindigkeit und die Messgenauigkeit beträchtlich gesteigert werden.

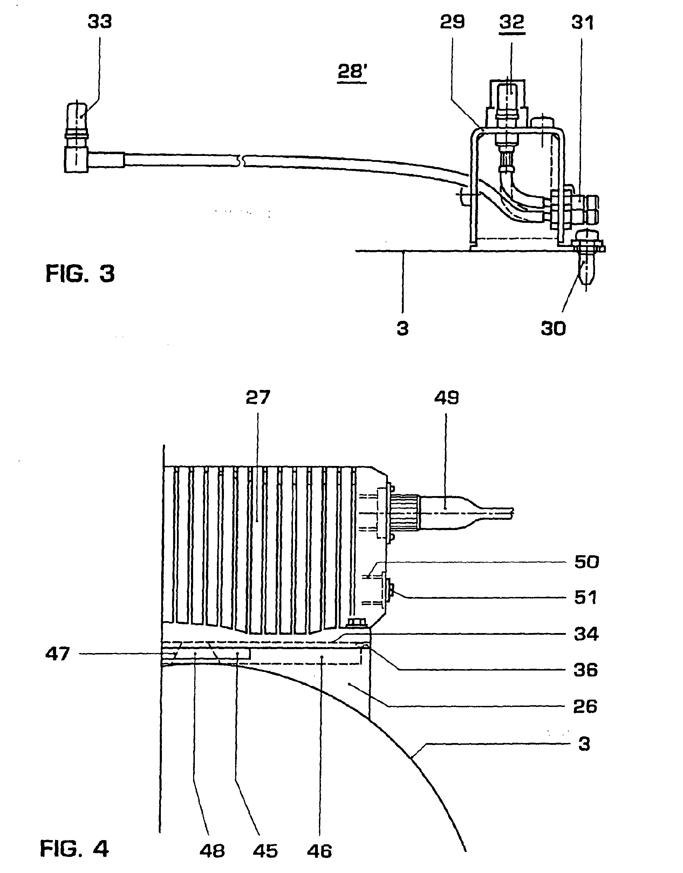

Die die Ausgangssignale der Sensoren in das Metallgehäuse führenden abgeschirmten Messkabel sind an eine in Inneren des Metallgehäuses angeordnete Steckvorrichtung 28 bzw. 28' geführt. Die Steckvorrichtung 28 bzw. 28' weist ein in einer quer zur Steckrichtung erstreckten ebenen Auflagefläche des umrandeten Bereichs des Kapselungsrohrs 3 schwimmend gelagertes Steckteil auf. Dieses Steckteil ist in Fig.3 für die Steckvorrichtung 28' dargestellt. Es weist eine gewinkelt ausgebildete und ein Z-winkelförmiges Profil enthaltende Federleiste 29 auf. Ein in der ebenen Auflagefläche geführter unterer Schenkel des Z-Winkels ist mittels am Kapselungsrohr gehaltener Schrauben 30 schwimmend gelagert. Ein L-förmig angesetzter mittlerer Schenkel des Z trägt ein mit einem Steckkontakt des Messkabels elektrisch leitend verbindbares Kupplungsstück 31. Der an den mittleren Schenkel angesetzte obere Schenkel des Z trägt ein mit dem Kupplungsstück 31 verbundenes Kupplungsstück 32, welches mit einem aus Fig.4 ersichtlichen Stecker 45 der Auswertevorrichtung 23 zusammenwirkt. Ein Steckkontakt des Kupplungstücks 31 kann über ein langes Leiterstück mit einem Steckkontakt 33 verbunden sein, welcher im benachbarten Metallgehäuse mit einem auf der Federleiste der Steckvorrichtung 28 angeordneten Kupplungsstück zusammenwirkt.

Alternativ kann der mittlere Schenkel des Z relativ kurz ausgebildet sein. Das Kupplungstück 31 kann dann an der Unterseite des oberen Schenkels des Z angebracht und direkt mit dem Kupplungstück 32 verbunden sein.

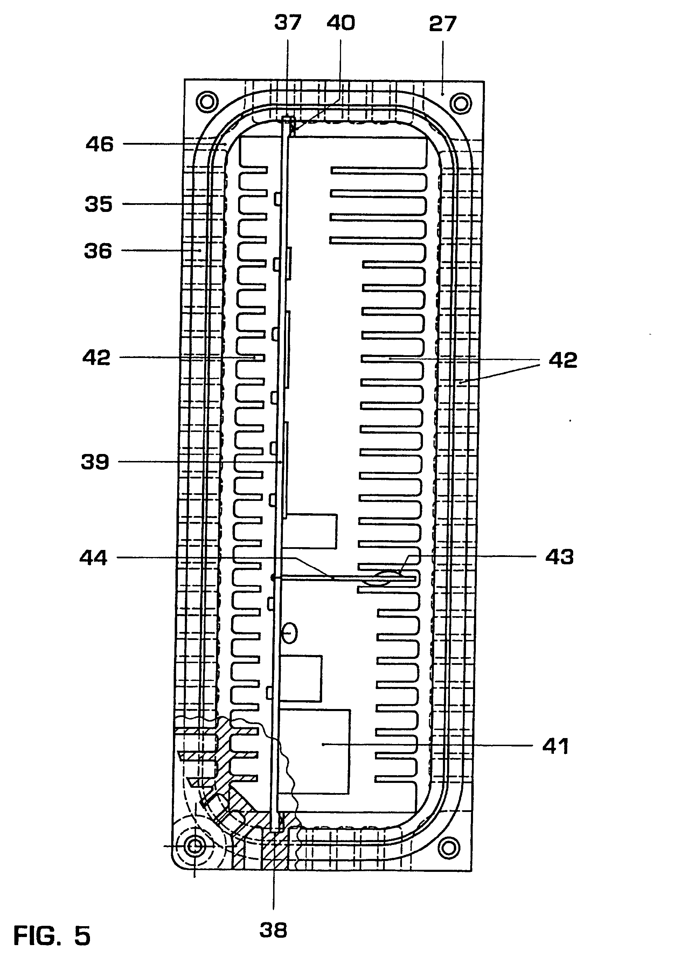

Aus den Figuren 4 und 5 sind der Aufbau und die Anordnung des die Auswertevorrichtung 23 bzw. 23' enthaltenden Metallgehäuses ersichtlich. Der Hohlflansch 26 weist eine um die Flanschöffnung geführte ebene Kontaktfläche 34 (Fig.4) auf, welche mit einer um die Trogöffnung geführten ebenen Kontaktfläche 35 des Trogrands (Fig.5) unter Bildung einer galvanischen Verbindung zusammenwirkt. Die beiden im wesentlichen vom Hohlflansch 26 und dem Gehäuseelement 27 gebildeten Teile des Metallgehäuses sind so miteinander elektrisch leitend verbunden und bilden einen Faradaykäfig für die Auswertevorrichtung. Die beiden ringförmig geschlossenen Kontaktflächen sind von mindestens einem zwischen dem Hohlflansch 26 und dem Trogrand eingespannten O-Ring 36 umgeben. Hierdurch wird eine praktisch gasdichte Verbindung der beiden Gehäuseteile erreicht und werden zugleich die beiden Kontaktflächen 34 und 35 vor von aussen zutretenden Schadstoffen geschützt.

Auf einander gegenüberstehenden Innenflächen des Gehäuseelementes 27 ist jeweils mindestens eine sich vom Trogrand in Richtung des Trogbodens erstreckende Nut 37 bzw. 38 eingeformt (Fig.5). Diese Nut dient der Aufnahme einer Kante einer mit einem oder mehreren Steckkontakten der Steckvorrichtung 28 bzw. 28' elektrisch leitend verbindbaren Printplatte 39 der Auswertevorrichtung. Die Nut 37 bzw. 38 ist mit Übermass ausgeführt und nimmt zusätzlich am Rand der Printplatte 39 angebrachte Kontaktfedern 40 auf. Mit den Kontaktfedern verbundene Leiterbahnen der Printplatte 39 werden so auf das Potential des Metallgehäuses geführt. Auf der Printplatte 39 befindliche elektronische Komponenten mit einer mit den Kontaktfedern 40 galvanisch verbundenen Umhüllung 41 werden so elektromagnetisch abgeschirmt.

In das trogförmige Gehäuseelement 27 sind innen und/oder aussen Kühlrippen 42 eingeformt. Die inneren Kühlrippen nehmen von den elektronischen Komponenten gebildete Wärme auf. Diese Wärme wird nach aussen geleitet und von den äusseren Kühlrippen an die Umgebung abgegeben.

Die inneren Kühlrippen können zusätzliche Aufgaben erfüllen. Wie aus Fig.5 ersichtlich ist, können zwischen zwei benachbart angeordneten Kühlrippen 42 ein Rand und Kontaktfedern 43 einer plattenförmig ausgebildeten und zwischen zwei elektronischen Komponenten angeordneten elektromagnetischen Abschirmung 44 der Auswertevorrichtung angeordnet sein. Diese Abschimung 44 wirkt als elektromagnetische Barriere zwischen den benachbarten elektronischen Komponenten.

Die Trogöffnung ist abgeschlossen mit einer elektromagnetisch schirmenden Deckplatte sowie mit dem durch eine Öffnung der Deckplatte geführten Stecker 45, welcher mit dem Kupplungsstück 32 zusammenwirkende Steckkontakte trägt. Das Gehäuseelement 27 weist einen den Trogrand überragenden und durch die Flanschöffnung des Hohlflansch 26 geführten Kragen 46 auf. Der Kragen 46 steht zudem über den Stecker 45 vor und weist eine mit einer Auskragung 47 des Hohlflansches 26 zusammenwirkende Materialaussparung 48 auf (Fig.4).

Der Kragen 46 erfüllt folgende Funktionen: Bei der Montage der Messvorrichtung führt er das Gehäuseelement 27 in den Hohlflansch 26. Hierbei stellt die als Kodierung mit der Materialaussparung 48 zusammenwirkende Auskragung 47 sicher, dass das Gehäuseelement 27 und damit der Stecker 45 in der richtigen Lage in das Kupplungsstück 32 eingeführt wird. Es wird so ausgeschlossen, dass das Ausgangssignal etwa einer der Rogowskispulen 11 durch eine falsche Steckverbindung an eine zu dessen Verarbeitung ungeeignete Elektronikkomponente der Auswertevorrichtung geführt wird. Da der Kragen 46 über den Stecker 45 vorsteht, kann beim Zusammenbau der Stecker 45 nicht mit einem Teil des Hohlflansches in Berührung kommen und hierbei beschädigt werden.

Beim Zusammenbau ist es von Vorteil, dass die Federleiste 29 schwimmend gelagert ist. Nicht zu vermeidende Lageabweichungen des Kupplungsstücks 32 und des Steckers 45 können so in besondes einfacher Weise kompensiert werden.

Wie aus Fig.4 ersichtlich ist, ist am Gehäuseelement 27 ein Stecker 49 angebracht, welcher mit einem durch die Wand des Gehäuseelement 27 geführten und mit der Auswertevorrichtung 23 bzw. 23' verbundenen Kupplungsstück zusammenwirkt. Durch die so gebildete Steckverbindung kommuniziert die Auswertevorrichtung 23 bzw. 23' vorzugsweise über störfreie Lichtwellenleiter mit einer übergeordneten Leittechnik und wird die Auswertevorrichtung 23 bzw. 23' über eine Drahtverbindung gleichzeitig mit elektrischer Energie versorgt. Die Kommunikation umfasst vor allem die Übermittlung digitalisierter Messwerte, etwa des Stromes, der Spannung, der Temperatur, des Drucks oder der Dichte, an die Leittechnik, kann aber auch der Übermittlung von in der Leittechnik gebildeter Information an die Auswerteeinheit 23 bzw. 23' dienen.

Bezugszeichenliste
- 1, 2: Flansche
- 3: Kapselungsrohr
- 4, 5: Rohrabschnitte
- 6: Schrauben
- 7: Dichtungsring
- 8: Achse
- 9: Stromleiter
- 10: Rogowskispulen
- 11: Messelektrode
- 12: Schrauben
- 13: Eingussarmatur
- 14: Isolator
- 15: Tragring
- 16: Haltering
- 17, 18: Schrauben
- 19, 20: Leiterabschnitte
- 21, 22: Abschirmungen
- 23, 23': Auswertevorrichtungen
- 24: Gleitkontakt
- 25: Schrauben
- 26: Hohlflansch
- 27: Gehäuseelement
- 28, 28': Steckvorrichtungen
- 29: Federleiste
- 30: Schrauben
- 31, 32: Kupplungsstücke
- 33: Steckkontakte
- 34, 35: Kontaktflächen
- 36: O-Ring
- 37, 38: Nuten
- 39: Printplatte
- 40: Kontaktfedern
- 41: Abschirmung
- 42: Kühlrippen

- 43: Kontaktfedern
- 44: Abschirmung
- 45: Stecker
- 46: Kragen
- 47: Auskragung
- 48: Materialaussparung
- 49: Stecker

## Patentansprüche

1. Messvorrichtung für eine metallgekapselte, gasisolierte Hochspannungsanlage mit mindestens einer in einem isoliergasgefüllten Kapselungsrohr (3) der Metallkapselung angeordneten Rogowskispule (10) zur Erfassung des Stromes eines durch das Kapselungsrohr (3) geführten stromführenden Leiters (9), mit mindestens einer den Leiter (9) umgebenden Messelektrode (11) zur Erfassung der Spannung des Leiters (9) und mit mindestens einer Ausgangssignale der Rogowskispule (10) und der Messelektrode (11) verarbeitenden elektronischen Auswertevorrichtung (23, 23'), **dadurch gekennzeichnet, dass** der Stromleiter (9) starr verbunden ist mit einer stromleitenden Eingussarmatur (13) eines am Kapselungsrohr (3) befestigten Isolators (14).

2. Messvorrichtung nach Anspruch 1, **dadurch gekennzeichnet, dass** der Stromleiter (9) mindestens zweiteilig ausgebildet ist, wobei ein erstes Teil (19) des Stromleiters (9) mit Hilfe von Schrauben (12), die in Richtung der Rohrachse (8) geführt sind, an der Eingussarmatur (13) befestigt ist.

3. Messvorrichtung nach Anspruch 2, **dadurch gekennzeichnet, dass** das erste Teil (19) hohl ausgebildet ist und in seinem Inneren mindestens einen Gleitkontakt (24) aufweist, auf welchem das zweite Teil (20) in Richtung der Rohrachse (8) verschieblich in elektrisch leitender Weise gelagert ist.

4. Messvorrichtung nach einem der Ansprüche 1 bis 3, **dadurch gekennzeichnet, dass** am Stromleiter (9) zusätzlich vorgesehene Abschirmungen (21, 22) starr mit dem Leiter (9) verschraubt sind.

5. Messvorrichtung nach einem der Ansprüche 1 bis 4, **dadurch gekennzeichnet, dass** der Isolator (14) mit Hilfe eines axial gegen den Isolator (14) geführten Halteringes (16) mittels Schrauben (17) am Kapselungsrohr (3) fixiert ist.

6. Messvorrichtung nach einem der Ansprüche 2 bis 5, **dadurch gekennzeichnet, dass** die Schrauben (12, 17) mit Hilfe einer Versiegelung oder einer Plombierung gegen unbefugtes Betätigen geschützt sind.

7. Messvorrichtung nach einem der Ansprüche 1 bis 6, **dadurch gekennzeichnet, dass** Kenngrössen und Kalibrierdaten von die Rogowskispule (10) und die Messelektrode (11) enthaltenden Sensoren sowie von gegebenenfalls vorgesehenen weiteren Sensoren, etwa zur Erfassung von Teilentladungen oder von Gaseigenschaften, wie Dichte, Temperatur und Druck, in einem von der Auswertevorrichtung (23, 23') abrufbaren, nicht überschreibbaren Datenspeicher abgelegt sind.

8. Messvorrichtung nach Anspruch 7, **dadurch gekennzeichnet, dass** der Datenspeicher durch eine Versiegelung oder Plombierung gegen unbefugtes Betätigen geschützt im Inneren des Metallgehäuses angeordnet ist.

9. Messvorrichtung nach einem der Ansprüche 1 bis 8, **dadurch gekennzeichnet, dass** neben der mindestens einen Auswertevorrichtung (23) mindestens eine weitere Auswertevorrichtung (23') vorgesehen ist, welche bei Ausfall der mindestens einen Auswertevorrichtung (23) deren Aufgaben übernimmt.

10. Messvorrichtung nach einem der Ansprüche 1 bis 9, **dadurch gekennzeichnet, dass** die Auswertevorrichtung (23, 23') in einem staubdicht ausgebildeten, zweiteiligen Metallgehäuse angeordnet ist, dessen eines Teil von einem an die Aussenfläche des Kapselungsrohrs (3) angeformten metallenen Hohlflansch (26) und dem vom Hohlflansch (26) umrandeten Bereich des Kapselungsrohrs (3) gebildet ist, und dessen anderes Teil ein trogförmig vertieftes Gehäuseelement (27) ist, welches mit seinem die Trogöffnung begrenzenden Rand am metallenen Hohlflansch (26) des Kapselungsrohrs (3) befestigt ist.

## Claims

1. Measuring device for a metal-enclosed, gas-insulated high-voltage installation having at least one Rogovski coil (10), which is arranged in an enclosure tube (3), filled with insulating gas, of the metal enclosure and serves to detect the current in a current-carrying conductor (9) led through the enclosure tube (3), having at least one measuring electrode (11), which surrounds the conductor (9) and serves to detect the voltage of the conductor (9), and having at least one electronic evaluation device (23, 23'), which processes output signals of the Rogovski coil (10) and the measuring electrode (11), **characterized in that** the current conductor (9) is rigidly connected to a current-conducting cast armature (13) of an insulator (14) fastened to the enclosure tube (3).

2. Measuring device according to Claim 1, **characterized in that** the current conductor (9) is constructed in at least two parts, a first part (19) of the current conductor (9) being fastened to the cast armature (13) with the aid of screws (12) which are guided in the direction of the tube axis (8).

3. Measuring device according to Claim 2, **characterized in that** the first part (19) is of hollow construction and has in its interior at least one sliding contact (24), on which the second part (20) is supported in an electrically conducting fashion and displaceably in the direction of the tube axis (8).

4. Measuring device according to one of Claims 1 to 3, **characterized in that** on the current conductor (9) additionally provided shields (21, 22) are rigidly screwed to the conductor (9).

5. Measuring device according to one of Claims 1 to 4, **characterized in that** the insulator (14) is fixed on the enclosure tube (3) by means of screws (17) with the aid of a holding ring (16) guided axially against the insulator (14).

6. Measuring device according to one of Claims 2 to 5, **characterized in that** the screws (12, 17) are protected against unauthorized operation with the aid of a seal.

7. Measuring device according to one of Claims 1 to 6, **characterized in that** characteristics and calibration data of sensors containing the Rogovski coil (10) and the measuring electrode (11), and of further sensors possibly provided, for example to detect partial discharges or gas characteristics such as density, temperature and pressure, are stored in a read-only data memory which can be called by the evaluation device (23, 23').

8. Measuring device according to Claim 7, **characterized in that** the data memory is arranged in the interior of the metal housing protected against unauthorized operation by a seal.

9. Measuring device according to one of Claims 1 to 8, **characterized in that** there is provided in addition to the at least one evaluation device (23) at least one further evaluation device (23'), which in the event of a failure of the at least one evaluation device (23) takes over its tasks.

10. Measuring device according to one of Claims 1 to 9, **characterized in that** the evaluation device (23, 23') is arranged in a bipartite metal housing which is of dustproof construction and whose one part is formed by a hollow metal flange (26), integrally formed on the outer surface of the enclosure tube (3), and the region of the enclosure tube (3) bordered by the hollow flange (26), and whose other part is a housing element (27), recessed in the form of a trough, which is fastened with its rim, bounding the trough opening, to the hollow metal flange (26) of the enclosure tube (3).

## Revendications

1. Appareil de mesure pour une installation blindée à haute tension à isolation de gaz avec au moins une bobine de Rogowski (10) disposée dans un conduit blindé (3) rempli de gaz isolant du blindage métallique pour déterminer le courant d'un conducteur (9) conduisant le courant amené à travers le conduit blindé (3), avec au moins une électrode de mesure (11) entourant le conducteur (9) pour déterminer la tension du conducteur (9) et avec au moins un appareil d'analyse (23, 23') électronique traitant les signaux de sortie de la bobine de Rogowski (10) et de l'électrode de mesure (11), **caractérisé en ce que** le conducteur de courant (9) est relié de façon rigide à une armature de coulée (13) conduisant le courant d'un isolant (14) fixé au conduit blindé (3).

2. Appareil de mesure selon la revendication 1, **caractérisé en ce que** le conducteur de courant (9) est réalisé au moins en deux parties, une première partie (19) du conducteur de courant (9) étant fixée à l'armature de coulée (13) à l'aide de vis (12) disposées en direction de l'axe du conduit (8).

3. Appareil de mesure selon la revendication 2, **caractérisé en ce que** la première partie (19) est réalisée de façon creuse et présente à l'intérieur au moins un contact glissant (24) sur lequel la deuxième partie (20) est disposée de façon coulissante et électriquement conductrice en direction de l'axe de conduit (8).

4. Appareil de mesure selon l'une quelconque des revendications 1 à 3, **caractérisé en ce que** des écrans antiparasites (21, 22) prévus en outre au niveau du conducteur de courant (9) sont vissés de façon rigide au conducteur (9) .

5. Appareil de mesure selon l'une quelconque des revendications 1 à 4, **caractérisé en ce que** l'isolant (14) est fixé au conduit blindé (3) à l'aide d'une bague de maintien (16) disposée de façon axiale contre l'isolant (14) à l'aide de vis (17).

6. Appareil de mesure selon l'une quelconque des revendications 2 à 5, **caractérisé en ce que** les vis (12, 17) sont protégées contre toute manipulation non intentionnelle à l'aide d'un scellement et/ou d'un plombage.

7. Appareil de mesure selon l'une quelconque des revendications 1 à 6, **caractérisé en ce que** les paramètres caractéristiques et les données d'étalonnage des capteurs contenant la bobine de Rogowski (10) et l'électrode de mesure (11) ainsi que des autres capteurs également prévus, par exemple pour déterminer les décharges partielles ou les propriétés du gaz telles que la densité, sa température et sa pression, sont mémorisés dans une mémoire de données ne pouvant pas être écrasée et pouvant être interrogée par un appareil d'analyse (23, 23').

8. Appareil de mesure selon la revendication 7, **caractérisé en ce que** la mémoire de données est disposée de façon protégée contre toute manipulation non intentionnelle à l'intérieur du boîtier métallique à l'aide d'un scellement ou d'un plombage.

9. Appareil de mesure selon l'une quelconque des revendications 1 à 8, **caractérisé en ce qu'**au moins un autre appareil d'analyse (23') est prévu en plus de l'au moins un appareil d'analyse (23), ledit appareil d'analyse reprenant les fonctions de l'autre appareil en cas de panne de l'au moins un appareil d'analyse (23).

10. Appareil de mesure selon l'une quelconque des revendications 1 à 9, **caractérisé en ce que** l'appareil d'analyse (23, 23') est disposé dans un boîtier métallique en deux parties réalisé de façon étanche à la poussière dont une partie est formée par une bride creuse (26) métallique formée au niveau de la surface extérieure du conduit blindé (3) et par la zone du conduit blindé (3) entourant la bride creuse (26), et dont l'autre partie est un élément de boîtier (27) creusé en forme d'auge fixé à la bride creuse (26) métallique du conduit blindé (3) avec son bord délimitant l'ouverture de l'auge.
